# EUROPEAN PATENT SPECIFICATION

(11) **EP 3 376 844 B1**
(45) Date of publication and mention of the grant of the patent: **17.05.2023**
(21) Application number: 15908293.2
(22) Date of filing: 11.11.2015
(51) Int. Cl.: H05K 13/08

(54) **IMAGE PROCESSING DEVICE AND IMAGE PROCESSING METHOD FOR BASE PLATE**
BILDVERARBEITUNGSVORRICHTUNG UND BILDVERARBEITUNGSVERFAHREN FÜR GRUNDPLATTE
DISPOSITIF DE TRAITEMENT D'IMAGE ET PROCÉDÉ DE TRAITEMENT D'IMAGE POUR PLAQUE DE BASE

(43) Date of publication of application: 19.09.2018
(73) Proprietor: Fuji Corporation, Chiryu-shi, Aichi 472-8686 (JP)
(72) Inventor: OYAMA, Shigeto, Chiryu Aichi (JP); USHII, Satoshi, Chiryu Aichi (JP)
(74) Representative: Grünecker Patent- und Rechtsanwälte PartG mbB
(86) International application number: PCT/JP2015/081767
(87) International publication number: WO 2017/081773

(56) References cited:
- JP-A- H04 340 799
- JP-A- 2000 201 000
- JP-A- 2003 086 996
- JP-A- 2008 218 538
- JP-A- 2009 170 516
- US-A1- 2002 168 097
- US-A1- 2006 048 383

## Description

### Technical Field

The present invention relates to a board image processing device and a board image processing method.

### Background Art

For example, PTL 1 discloses a configuration of recognizing a reference position of a board loaded in a component mounting machine. For example, in the recognition of the reference position of the board, a wiring pattern of the board is imaged and a characteristic section in the wiring pattern is detected as a fiducial mark from acquired image data. In addition, in the detection described above, a template showing the characteristic section in the wiring pattern is used, the template using reference lines formed from a shape that follows edge sections of the characteristic section and multiple seek lines which intersect with the edge sections.

### Citation List

### Patent Literature

PTL 1: JP-A-2003-086996
Further examples of board image processing are disclosed in US 2002/168097 A1, US 2006/048383 A1, JP 2009 170516 A and JP H04 340799 A.

### Summary of Invention

### Technical Problem

However, in a case where the characteristic section of the wiring pattern is not detected by the detection, an image processing device displays the image data for an operator so that the operator can set the reference position in the image data to be used during the detection process. However, there is a concern that setting of the reference position through a manual operation performed by an operator will contain an error due to visual measurement being used. For example, in order to optimally maintain accuracy of a mounting process of the component mounting machine, it is desirable to recognize the reference position of the board with high accuracy.

The present invention is made in consideration of such circumstances, and an object thereof is to provide a board image processing device and a board image processing method in which it is possible to recognize a reference position of the board with higher accuracy.

### Solution to Problem

The present invention is defined in the independent claims. Preferred embodiments are laid down in the dependent claims.

### Advantageous Effects of Invention

In these configurations according to the present invention, in a case where it is not possible to detect the position of a fiducial mark, any characteristic section other than the fiducial mark of one or multiple of the characteristic sections in the wiring pattern can be acquired as an alternative mark, and a supplementary process using the alternative mark can be performed. In this manner, since the reference position of the board is automatically recognized, it is possible to recognize the reference position with high accuracy, compared to a case where the reference position of the board is set through a manual operation performed by the operator. Accordingly, by performing the supplementary process in a mounting process performed by a component mounting machine, it is possible to optimally maintain accuracy of the mounting process.

### Brief Description of Drawings

[Fig. 1] Fig. 1 is a schematic diagram illustrating a production line to which a board image processing device of a first embodiment is applied.
[Fig. 2] Fig. 2 is a diagram illustrating an upper face of a multi-unit board.
[Fig. 3] Fig. 3 is a diagram illustrating a state in which a first template is superimposed on image data obtained by imaging a part of the board in Fig. 2.
[Fig. 4] Fig. 4 illustrates a flowchart of image processing for recognizing a reference position of the board.
[Fig. 5] Fig. 5 illustrates a screen of a display device, on which image data obtained by imaging the board is displayed, and a state of accepting an input of alternative mark information through manual operation performed by an operator.
[Fig. 6] Fig. 6 illustrates a flowchart of a setting process of alternative mark information in a second embodiment.
[Fig. 7] Fig. 7 illustrates a candidate table and a table of a relationship between a target fiducial mark and a candidate mark.

### Description of Embodiments

Hereinafter, specific embodiments of a board image processing device of the present invention will be described with reference to the figures. In the embodiments, an example configuration is given in which a board image processing device is installed in a component mounting machine that configures a production line for manufacturing a circuit board product such as an integrated circuit is.

### First Embodiment

### Configuration of Production Line 1

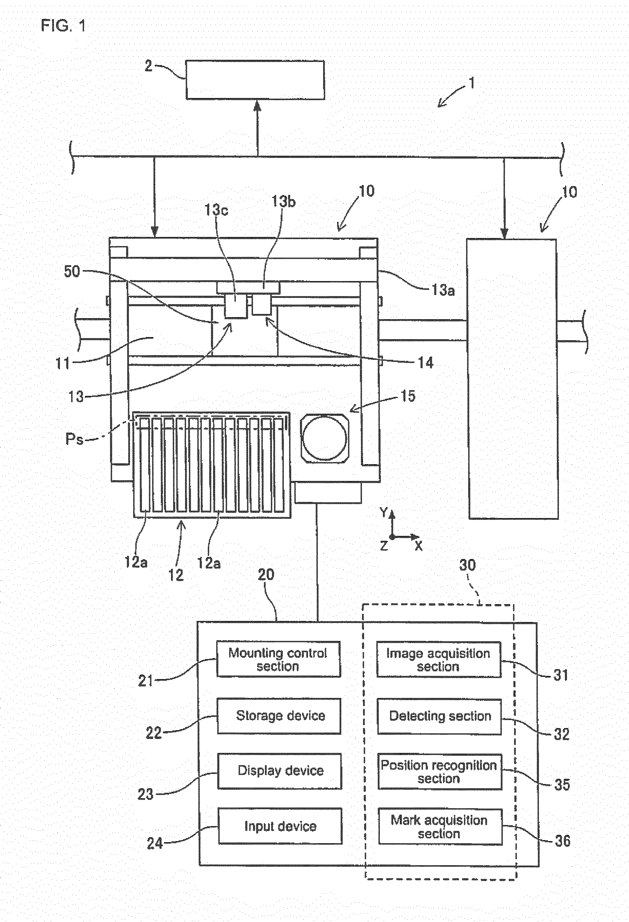

As illustrated in Fig. 1, production line 1 is configured with multiple production equipments that are connected to host computer 2 via a network such that communication between them is possible. Examples of production equipment include a screen printer, a mounting inspector, a reflow oven, or the like, in addition to component mounting machine 10. The production equipment including component mounting machine 10 is configured to be capable of inputting and outputting various types of data to and from host computer 2 via the network.

Host computer 2 monitors an operating state of production line 1 and controls the production equipment including component mounting machine 10. Host computer 2 stores various types of data for controlling component mounting machine 10. The various types of data include a production plan including a type and amount of a circuit board product to be produced, a control program for causing component mounting machine 10 to operate, and a template that is used in an image processing. Host computer 2 appropriately transmits various types of data such as the control program to the production equipment during execution of a production process by the production equipment.

### Configuration of Component Mounting Machine 10

As illustrated in Fig. 1, multiple component mounting machines 10 that configure production line 1 include board conveyance device 11, component supply device 12, component transfer device 13, component camera 14, board camera 15, and control device 20. In the following description, a horizontal width direction (left-right direction in Fig. 1) of component mounting machine 10 is referred to as an X-axis direction, a horizontal depth direction (up-down direction in Fig. 1) of component mounting machine 10 is referred to as a Y-axis direction, and a vertical direction (front-rear direction in Fig. 1) perpendicular to the X-axis direction and the Y-axis direction is referred to as a Z-axis direction.

Board conveyance device 11 is configured with a belt conveyor and conveys boards 50 in a conveyance direction (X-axis direction in the embodiment) in a sequential order. Board conveyance device 11 positions board 50 at a predetermined position in component mounting machine 10. Board conveyance device 11 conveys the board 50 out of component mounting machine 10 after the mounting process is executed by component mounting machine 10.

Component supply device 12 supplies electronic components, which are mounted on board 50, at a supply position Ps. Component supply device 12 is provided with multiple slots aligned in the X-axis direction. The multiple slots are all set such that a feeder 12a can be attached and detached. For example, component supply device 12 causes feeder 12a to feed and move a carrier tape so as to supply an electronic component at a pickup section positioned on a front end side (upper side in Fig. 1) of feeder 12a.

Component transfer device 13 is configured to be capable of moving in the X-axis direction and the Y-axis direction. Component transfer device 13 is disposed from a rear side (upper side in Fig. 1) of component mounting machine 10 in the depth direction to a position above component supply device 12 on a front side. Component transfer device 13 includes head driving device 13a, moving table 13b, and mounting head 13c. Head driving device 13a has a configuration in which a linear motion mechanism causes moving table 13b to be movable in the XY-axis directions.

Mounting head 13c is clamped to be fixed to moving table 13b via a frame (not illustrated). In addition, multiple suction nozzles (not illustrated) are detachably provided on mounting head 13c. Mounting head 13c supports the suction nozzles in a liftable/lowerable manner and in a rotatable manner around an R-axis that is parallel to the Z-axis. A lifting and lowering position and an angle with respect to the mounting head 13c, and a supply state of negative pressure of the suction nozzles are controlled. By negative pressure being supplied to the suction nozzles, the suction nozzles pick up and hold an electronic component that is supplied at the pickup section of feeder 12a.

Component camera 14 and board camera 15 are digital imaging devices having an imaging element such as a charge coupled device (CCD) or a complementary metal oxide semiconductor (CMOS) . Component camera 14 and board camera 15 perform imaging in a range of a camera field-of-view, based on a control signal by control device 20, which is connected to be capable of communicating, and transmit image data acquired by the imaging to control device 20.

Component camera 14 is fixed to a base of component mounting machine 10 such that an optical axis is formed upward in the vertical direction (Z-axis direction) , and is configured to be capable of performing the imaging from below component transfer device 13. More specifically, component camera 14 is configured to be capable of imaging a lower face of the electronic component that is in a state of being held by the suction nozzle. Board camera 15 is provided on moving table 13b of component transfer device 13 such that an optical axis is formed downward in the vertical direction (Z-axis direction) . Board camera 15 is configured to be capable of imaging board 50.

### Configuration of Control Device 20

Control device 20 is configured with mainly a CPU, various types of memories, and a control circuit. Control device 20 controls a mounting process of the electronic component. Control device 20 is connected to the host computer 2 via a network such that communication is possible. As illustrated in Fig. 1, control device 20 includes mounting control section 21, storage device 22, display device 23, input device 24, and image processing device 30.

Mounting control section 21 controls a position of mounting head 13c or motion of a suction mechanism. To be more exact, mounting control section 21 inputs results of various types of recognition processes and information that is output from various types of sensors provided on component mounting machine 10. Mounting control section 21 transmits a control signal to component transfer device 13, based on a control program stored in storage device 22, information obtained by the various types of sensors, and results of recognition processes performed by image processing device 30. In this manner, a position and a rotation angle of the suction nozzle supported by mounting head 13c are controlled.

Storage device 22 is configured with an optical drive device such as a hard disk device, a flash memory, or the like. Storage device 22 stores the control program, control information, image data, temporary data of various types of processes performed by image processing device 30. Display device 23 displays the various types of data as an image for the operator. Input device 24 is a device that accepts the input of the various types of data through a manual operation performed by the operator.

### Configuration of Image Processing Device 30

Image processing device 30 acquires image data obtained by imaging performed by component camera 14 and board camera 15 and executes appropriate image processing. For example, the image processing can include binarization of the image data, filtering, hue extraction, super-resolution processing, or the like. Image processing device 30 executes the image processing for recognizing the reference position of board 50.

Here, there are cases in which a positioning error is included in the position of board 50 loaded in board conveyance device 11. Therefore, control device 20 corrects the position of the suction nozzle that is held by mounting head 13c depending on a positioning state of board 50, based on the results of the image processing for recognizing the reference position of the board 50. In this manner, the electronic component is mounted at an optimal position of the board 50, and accuracy of the mounting process is improved.

In the recognition of the reference position of the board 50, a detection process of a fiducial mark having a given shape, which is disposed on an upper face of the board 50, is performed. In the embodiment, at least one of one or more characteristic sections contained in the wiring pattern formed on the upper face of the board is set as a fiducial mark indicating the reference position. In this manner, it is possible to recognize the reference position of the board 50 in a case where a fiducial mark is omitted so as to achieve high density of the board 50, a case where a positional relationship between the fiducial mark and the wiring pattern is not constant due to the configuration of the board 50, or the like.

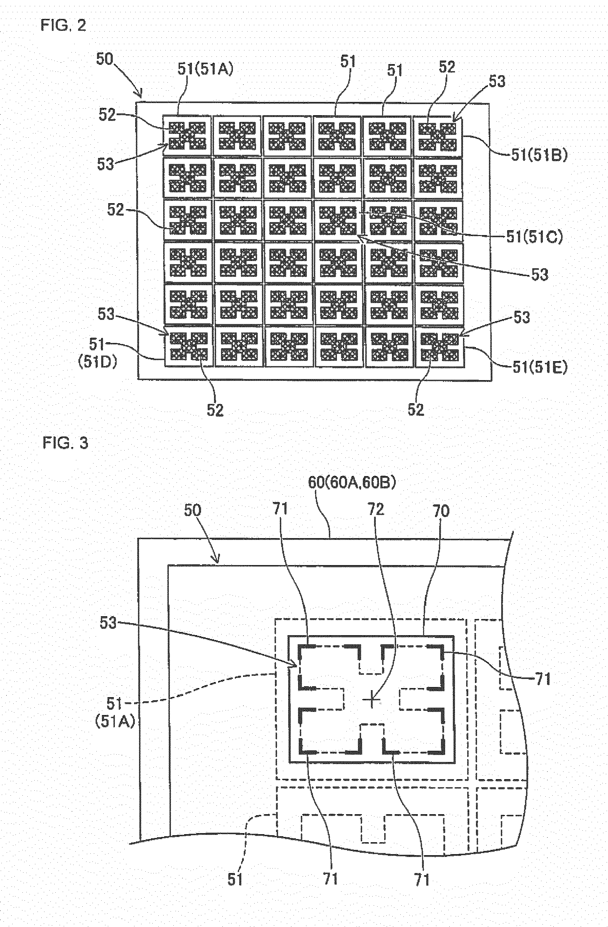

Here, as illustrated in Fig. 2, the board 50 in the embodiment is a multi-unit board configured with multiple unit boards 51. The multi-unit board is divided into individual unit boards after the mounting of the electronic components to become multiple electronic circuit products that are the same. The same wiring pattern is formed on each of the multiple unit boards 51. The wiring pattern of unit board 51 is configured with lands 52 that are electrically connected to a terminal of the electronic component via solder that is applied through printing or the like.

Land 52 of unit board 51 in the embodiment is configured from a combination of multiple rectangles and individually configures one wiring pattern and characteristic section 53 of the wiring pattern. In addition, characteristic sections 53 in five reference-use unit boards, 51A to 51E, which are selected by an operator from the total of 36 unit boards 51, are each set as fiducial marks indicating the reference positions of the board 50. Hereinafter, the characteristic sections 53 of the reference-use unit boards 51A to 51E are also referred to as fiducial marks Mt.

As illustrated in Fig. 1, image processing device 30 includes image acquisition section 31, detecting section 32, position recognition section 35, and mark acquisition section 36. Image acquisition section 31 acquires first image data 60A obtained by imaging a region of the board 50 which includes the fiducial mark Mt. The "region including the fiducial mark Mt" means a region that can be imaged by board camera 15 that is relatively moved with respect to the board 50.

Detecting section 32 detects a position of the fiducial mark Mt by scanning the first image data 60A by using template 70 (corresponding to a "first template" of the present invention) showing a shape of the fiducial mark Mt. Here, the template 70 that is used in the detection process is configured with a reference line, which has a shape that follows edges section of the fiducial mark Mt which is a detection target, and multiple seek lines disposed based on the shape of the edge portions. The template is stored in storage device 22.

In the embodiment, as illustrated in Fig. 3, the template 70 is configured with reference lines 71 having a shape that follows edge sections of the characteristic section 53, which is the fiducial mark Mt, and a specified point 72 indicating the position of the fiducial mark Mt in a case where the fiducial mark Mt is detected. In the template 70, a positional relationship between a position of the specified point 72 and the reference position of the board 50 is defined.

Position recognition section 35 recognizes the reference position of the board 50, based on a result of detection of the fiducial mark Mt through scanning performed by detecting section 32 with the template 70. Here, image processing device 30 needs to recognize the reference position of the board 50 by another method in a case where the position of the fiducial mark Mt is not detected through the scanning by using the template 70 described above. Image processing device 30 executes a supplementary process that supplements the detection process.

In the supplementary process, mark acquisition section 36 acquires a different characteristic section 53 that is different from the fiducial mark Mt as an alternative mark Mb instead of the fiducial mark Mt. The alternative mark Mb which is a new detection target is one characteristic section 53 of the wiring pattern disposed on the upper face of the same board 50. The shape of the alternative mark Mb is not limited to the same shape as that of the fiducial mark Mt and may have an abnormal shape.

In the embodiment, the alternative mark Mb is the characteristic section 53 formed on another unit board 51, which is different from the unit boards 51A to 51E for reference, and has the same shape as that of the fiducial mark Mt. In addition, it is possible to employ various ways as a method of acquiring the alternative mark Mb by mark acquisition section 36. The method of acquiring the alternative mark Mb is described below in detail.

In addition, in the supplementary process, the image acquisition section 31 acquires second image data 60B obtained by imaging a region including the alternative mark Mb of the board 50. Detecting section 32 detects the position of the alternative mark Mb by scanning the second image data 60B by using a second template showing a shape of the alternative mark Mb. Further, position recognition section 35 recognizes the reference position of the board 50 based on a result of detection performed by detecting section 32 and a positional relationship between the fiducial mark Mt and the alternative mark Mb.

Here, in the supplementary process, in a case where the alternative mark Mb is contained in the first image data 60A used for an initial detection process of detecting a position of the fiducial mark Mt by using the template 70, image acquisition section 31 acquires the first image data 60A as the second image data 60B. In the embodiment, the first image data 60A and the second image data 60B are identical and are simply referred to as "image data 60".

In addition, as described above, in the embodiment, each of the fiducial mark Mt and the alternative mark Mb is set at the same position and has the same shape in the wiring pattern. Therefore, the second template used for the supplementary process can serve as the template 70 (first template) used for the scanning of the fiducial mark Mt, and the second template is the same as the template 70.

Image acquisition section 31 having such a configuration as described above corresponds to a "first image acquisition section" and a "second image acquisition section" of the present invention. In addition, detecting section 32 corresponds to a "first detecting section" and a "second detecting section" of the present invention. Position recognition section 35 corresponds to a "first position recognition section" and a "second position recognition section" of the present invention.

In addition, display device 23 of control device 20 serves as a display section that displays a portion or the entirety of the board 50 from the image data 60 in the supplementary process. In addition, input device 24 of control device 20 serves as a setting accepting section that accepts designation of the alternative mark Mb and an input of the positional relationship between the fiducial mark Mt and the alternative mark Mb by an operator.

### Image Processing Performed by Image Processing Device 30

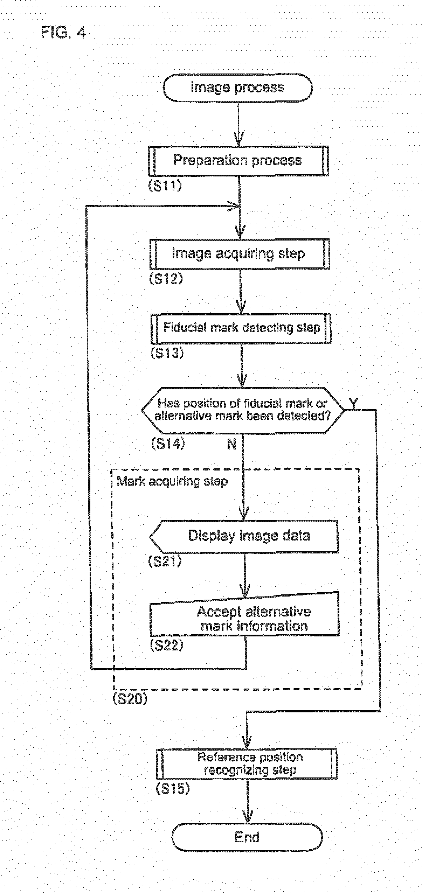

The image processing of recognizing the reference position of the board 50 by image processing device 30 for the board is described. For example, the image processing is executed for recognizing the reference position of the board 50 positioned by board conveyance device 11 in the mounting process of component mounting machine 10. As illustrated in Fig. 4, first, image processing device 30 executes a preparation process (Step 11 [hereinafter, "Step" is described as "S"]).

The preparation process (S11) contains an imaging process of imaging a region containing the fiducial mark Mt of the board 50 or a reading process of reading the template 70 showing the shape of the fiducial mark Mt from storage device 22. Next, image acquisition section 31 acquires, from storage device 22, the image data 60 obtained by imaging the fiducial mark Mt, as a first image acquiring step (S12) . Subsequently, as a first detecting step, detecting section 32 detects the position of the fiducial mark Mt by scanning the image data 60 by using the template 70 (S13).

Image processing device 30 determines whether the position of the fiducial mark Mt has been detected through the scanning performed by detecting section 32 (S14) . Specifically, in a case where all of the reference lines 71 of the template 70 are coincident with the edge sections of the image data 60 at a predetermined position in the image data 60 subjected to edge processing, it is determined that the fiducial mark Mt coincident with the template 70 is detected (S14: Yes). As a first position recognizing step, the position recognition section 35 recognizes the reference position of the board 50, based on the result of detection of the fiducial mark Mt through scanning performed by detecting section 32 (S15).

On the other hand, in a case where not all of the reference lines 71 are coincident with the edge sections of the image data 60, image processing device 30 determines that the position of the fiducial mark Mt is not detected (S14: No). As described above, in a case where it is not possible to detect the position of the fiducial mark Mt due to a factor such as absence of a part of the characteristic section 53 which is the fiducial mark Mt, the image processing device 30 executes the supplementary process by using the alternative mark Mb (S20 and S12 to S14).

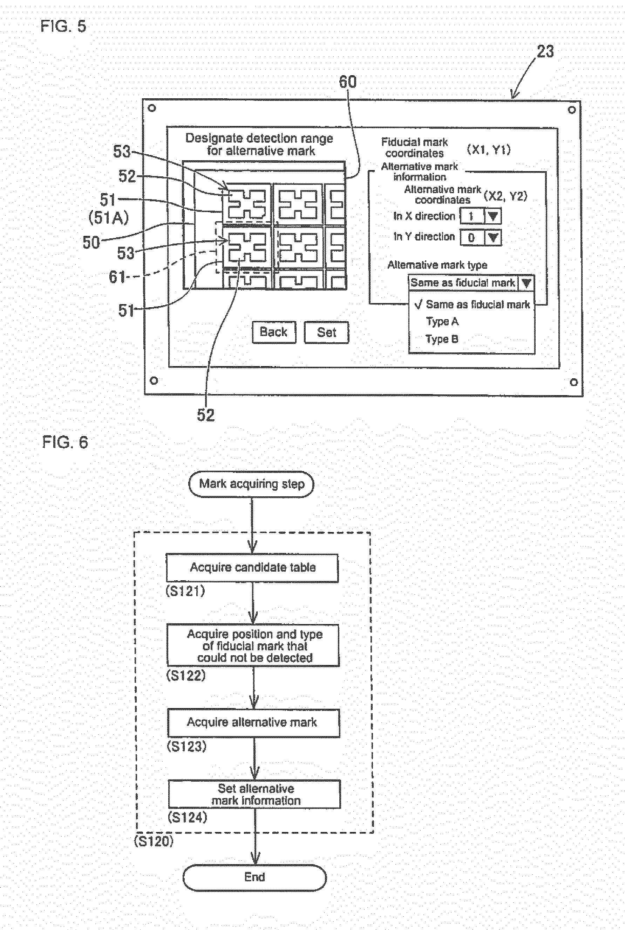

In the supplementary process, mark acquisition section 36 acquires a different characteristic section 53 that is different from the fiducial mark Mt as the alternative mark Mb instead of the fiducial mark Mt, as a mark acquiring step (S20). Specifically, as illustrated in Fig. 5, the board 50 is displayed for the operator (S21). At this time, display device 23 may display the entire board 50 or may further enlarge and display a portion of the board 50 in response to a request of an operator. In addition, mark acquisition section 36 accepts designation of the alternative mark Mb and an input of the positional relationship between the fiducial mark Mt and the alternative mark Mb by an operator (S22).

For example, a region is designated so as to surround a unit board 51 adjacent to the unit board 51A in the X-direction (up-down direction in Fig. 5) which has a characteristic section 53 set as the fiducial mark Mt, through an operation of a pointer device, a touch operation on a screen, or the like by the operator. In this manner, a designation region 61 containing the alternative mark Mb is set. Further, the operator inputs information on a coordinate of the alternative mark Mb and information on types of alternative mark Mb.

Here, in the embodiment, the board 50 is a multi-unit board, and storage device 22 stores a positional relationship between the multiple unit boards 51, that is, positional information indicating a distance in the XY-axis direction. Hence, the operator inputs how many unit boards 51 having the characteristic section 53 set as the alternative mark Mb are provided in the XY-axis directions with respect to the unit board 51A having the characteristic section 53 set as the fiducial mark Mt, and thereby mark acquisition section 36 is configured to establish a positional relationship between the fiducial mark Mt and the alternative mark Mb. In this manner, it is possible to omit the input of a relative position between the alternative mark Mb with respect to the fiducial mark Mt or a relative position of the alternative mark Mb with respect to the origin of the board 50.

In addition, the alternative mark Mb that is used in the supplementary process does not need to have the same shape as the fiducial mark Mt. Hence, mark acquisition section 36 accepts information on types of alternative mark Mb, and thereby is configured to acquire the alternative mark Mb corresponding to a type registered in advance. In the embodiment, the board 50 is a multi-unit board, and the position and the shape of the characteristic section 53 in each of the unit boards 51 are the same as the fiducial mark Mt. Hence, it is possible to omit the input of the position and the shape of the alternative mark Mb in the acceptance of information on the alternative mark Mb (S22). It is possible to set, as the alternative mark Mb, a characteristic section that is at another position and has another shape in the unit board 51 which is a target. Hence, the operator needs to input information indicating that the fiducial mark Mt and the alternative mark Mb are the same type and information indicating that the marks are at the same position, thereby designating that the fiducial mark Mt and the alternative mark Mb are the same characteristic section 53 in different unit boards 51.

Subsequently, image acquisition section 31 acquires the image data corresponding to designation region 61 as a second image acquiring step (S12). Here, since the alternative mark Mb is contained in the image data 60 used in the first detection process, the imaging process performed by board camera 15 is omitted, and image acquisition section 31 acquires the image data 60. On the other hand, in a case where the alternative mark Mb is not contained in the image data 60, image acquisition section 31 executes an imaging process performed by board camera 15.

As a second detecting step, detecting section 32 detects the position of the alternative mark Mb through scanning of the image data 60 by using the second template (in the embodiment, the template 70 having two functions) showing the shape of the alternative mark Mb (S13). Detecting section 32 acquires the template 70 used in the first detecting step, as the second template that is used in the second detecting step, based on information indicating that the type of alternative mark Mb is the same as the type of fiducial mark Mt.

Image processing device 30 determines whether the position of the alternative mark Mb has been detected through the scanning performed by detecting section 32 (S14). Specifically, in a case where all of the reference lines 71 of the template 70 are coincident with the edge sections of the image data 60 in designation region 61 designated by the operator, it is determined that the alternative mark Mb coincident with the template 70 is detected (S14; Yes). Position recognition section 35 recognizes the reference position of the board 50 based on the result of detection performed in the second detecting step (S13) and a positional relationship between the fiducial mark Mt and the alternative mark Mb, as a second position recognizing step (S15).

On the other hand, in a case where not all of the reference lines 71 are coincident with the edge sections of the image data 60, image processing device 30 determines that the position of the alternative mark Mb has not been detected (S14 : No). As described above, in a case where the position of the alternative mark Mb cannot be detected, image processing device 30 re-executes the supplementary process by using the alternative mark Mb (S20 and S12 to S14).

In a case where component mounting machine 10 transitions to the next production and another board 50 becomes a target, image processing device 30 executes the image processing of recognizing the reference position of the board 50, with the characteristic section 53 of the reference-use unit boards 51A to 51E which is designated first as the fiducial mark Mt. In other words, the supplementary process in which the alternative mark Mb is used in the image processing is an irregular process corresponding to a case where an undetectable characteristic section 53 is present, and it is determined with respect to each individual board 50 whether to perform the supplementary process.

### Second Embodiment

Configurations of an image processing device and an image processing method of the second embodiment are the same as those in the first embodiment, except for the mark acquiring step (S20) in the first embodiment. The other common configurations are substantially the same as those in the first embodiment, and thus detailed description is omitted. In the second embodiment, as illustrated in Fig. 6, when a mark acquiring step (S120) is executed, mark acquisition section 36 first acquires candidate table 80 (S121).

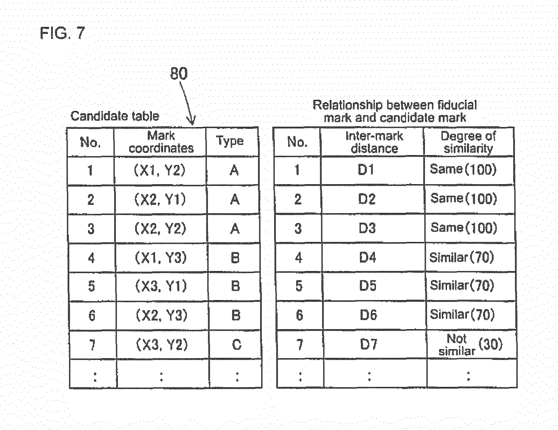

As illustrated in Fig. 7, in candidate table 80, a candidate mark, which is usable as the alternative mark Mb of multiple characteristic sections 53, is associated with a positional relationship (the "mark coordinate" column in Fig. 7) between the fiducial mark Mt and each of the multiple candidate marks . Further, in the embodiment, in candidate table 80, a type (the "type" column in Fig. 7) is associated as information on each shape of the candidate marks with the multiple candidate marks.

Next, mark acquisition section 36 acquires information on the fiducial mark Mt that was not detected through the scanning by using the template 70, as a first detecting step (S122). Specifically, mark acquisition section 36 identifies, from reference-use unit boards 51A to 51E, a unit board having undetectable fiducial mark Mt and acquires a position on the board 50 which is a multi-unit board. In this manner, as illustrated in Fig. 7, a relationship between the fiducial mark Mt and the candidate mark is established.

Subsequently, mark acquisition section 36 selects one candidate mark of the multiple candidate marks and acquires the candidate mark as the alternative mark Mb, based on a positional relationship (the "inter-mark distance" column in Fig. 7) between the fiducial mark Mt and each of the multiple candidate marks and a degree of similarity (the "degree of similarity" column in Fig. 7) between the shape of the fiducial mark Mt and the shape of each of the multiple candidate marks (S123). In other words, in the embodiment, the candidate table 80 is set in advance, and thereby the alternative mark Mb is automatically selected, based on the position and the type of undetectable fiducial mark Mt. It is preferable that a candidate mark that is closest to the fiducial mark Mt and is the same type as that of the fiducial mark Mt is used as a selected candidate mark.

Then, mark acquisition section 36 acquires information such as the positional relationship between the fiducial mark Mt and the acquired alternative mark Mb, from candidate table 80 (S124). After the alternative mark Mb is acquired in the mark acquiring step (S120), image processing device 30 executes the detection process by using the alternative mark Mb. The re-detection process is substantially the same as that in the first embodiment, and thus detailed description is omitted.

### Effects of Configurations of First and Second Embodiments

In image processing device 30 and the image processing method for the board, the reference position of the board 50, on which a wiring pattern is formed, is recognized. At least one of one or more characteristic sections 53 contained in the wiring pattern is set as a fiducial mark Mt indicating the reference position. The image processing device 30 includes: a first image acquisition section (image acquisition section 31) that acquires first image data 60A obtained by imaging a region of the board 50, in which the fiducial mark Mt is contained; a first detecting section (detecting section 32) that detects the position of the fiducial mark Mt by scanning the first image data 60A by using a first template (template 70) showing the shape of the fiducial mark Mt; a first position recognition section (position recognition section 35) that recognizes the reference position of the board 50, based on a result of detection performed by the first detecting section (detecting section 32); a mark acquisition section 36 that, in a case where the position of the fiducial mark Mt is not detected by the scanning performed by the first detecting section (detecting section 32), acquires a different characteristic section 53 that is different from the fiducial mark Mt as an alternative mark Mb instead of the fiducial mark Mt,; a second image acquisition section (image acquisition section 31) that acquires second image data 60B obtained by imaging a region of the board 50, in which the alternate mark Mb is contained; a second detecting section (detecting section 32) that detects the position of the alternative mark Mb by scanning the second image data 60B by using a second template (template 70) showing a shape of the alternative mark Mb; and a second position recognition section (position recognition section 35) that recognizes the reference position of the board 50 based on a result of the detection performed by the second detecting section (detecting section 32) and a positional relationship between the fiducial mark Mt and the alternative mark Mb.

The image processing method for the board includes: a first image acquiring step (S12) of acquiring first image data 60A obtained by imaging a region of the board 50, in which the fiducial mark Mt is contained; a first detecting step (S13) of detecting a position of the fiducial mark Mt by scanning the first image data 60A by using a first template (template 70) showing a shape of the fiducial mark Mt; a first position recognizing step (S15) of recognizing the reference position of the board 50, based on a result of detection performed in the first detecting step; a mark acquiring step (S20) of, in a case where the position of the fiducial mark Mt is not detected by the scanning performed in the first detecting step (S14: No), acquiring a different characteristic section 53 that is different from the fiducial mark Mt as an alternative mark Mb instead of the fiducial mark Mt; a second image acquiring step (S12) of acquiring second image data 60B obtained by imaging a region of the board 50, in which the alternative mark Mb is contained; a second detecting step (S13) of detecting the position of the alternative mark Mb by scanning the second image data 60B by using a second template (template 70) showing the shape of the alternative mark Mb; and a second position recognizing step (S15) of recognizing the reference position of the board 50 based on a result of the detection performed by the second detecting step and a positional relationship between the fiducial mark Mt and the alternative mark Mb.

In these configurations, in a case where it is not possible to detect the position of the fiducial mark Mt (S14: No), any characteristic portion other than the fiducial mark Mt of one or multiple characteristic sections 53 in the wiring pattern can be acquired as the alternative mark Mb, and the supplementary process using the alternative mark Mb can be executed (S20 and S12 to S14) . In this manner, since the reference position of the board 50 is automatically recognized, it is possible to recognize the reference position with high accuracy, compared to a case where the reference position of the board 50 is set through a manual operation performed by the operator. Accordingly, the supplementary process is executed in the mounting process performed by component mounting machine 10, and thereby it is possible to optimally maintain accuracy of the mounting process.

In addition, in the first and second embodiments, mark acquisition section 36 displays a portion or the entirety of the board 50 for an operator (S21) and accepts designation of the alternative mark Mb and an input of the positional relationship between the fiducial mark Mt and the alternative mark Mb (S22) by the operator.

In the configuration, it is possible to execute the supplementary process by using the alternative mark Mb acquired through designation by an operator (S20 and S12 to S14). In this manner, in the supplementary process, since the detection of the alternative mark Mb is performed and the reference position of the board 50 is automatically recognized (S15), it is possible to recognize the reference position with high accuracy, compared to a case where the reference position of the board 50 is set through a manual operation performed by the operator. In addition, it is possible to appropriately acquire the alternative mark Mb in response to a state in which an operator cannot detect the position of the fiducial mark Mt. As a result, it is possible to efficiently recognize the reference position of the board 50.

In the second embodiment, the mark acquisition section 36 has candidate table 80 in which the multiple candidate marks, which are usable as the alternative mark Mb of the characteristic sections 53, are associated with a positional relationship between the fiducial mark Mt and each of the multiple candidate marks. Mark acquisition section 36 acquires, as the alternative mark Mb, one of the multiple candidate marks selected based on the positional relationship between the fiducial mark Mt and each of the multiple candidate marks.

The fiducial mark Mt of the board 50 is at least one of the multiple characteristic sections 53 in the wiring pattern and is appropriately set depending on the mounting process, for example. In a case where it is not possible to detect the position of the fiducial mark Mt, the image processing device 30 can acquire, as the alternative mark Mb, one selected candidate mark (for example, closest candidate mark) based on the positional relationship between the candidate mark in candidate table 80 and the fiducial mark Mt. In this manner, in the mark acquiring step (5120), it is possible to automatically acquire the alternative mark Mb without the manual operation performed by the operator. Accordingly, it is possible to shorten a time taken for the mark acquiring step (S120), and it is possible to shorten a cycle time of the mounting process in component mounting machine 10 to which image processing device 30 is applied, for example.

In addition, in the second embodiment, in candidate table 80, information on each shape of the candidate marks is associated with the multiple candidate marks. Mark acquisition section 36 acquires, as the alternative mark Mb, one of the multiple candidate marks selected based on a degree of similarity between the shape of the fiducial mark Mt and the shape of each of the multiple candidate marks.

In the configuration described above, one candidate mark is selected from candidate table 80 based on a degree of similarity between the shape of the fiducial mark Mt and the shape of each of the multiple candidate marks, and the candidate mark is acquired as the alternative mark Mb. In this manner, it is possible to set a more appropriate candidate mark as the alternative mark Mb to be used as the fiducial mark Mt. In addition, when the degree of similarity is increased, it is possible to share a portion or the entirety of the first template (template 70) as the second template.

Here, in the first and second embodiments, the board 50 is a multi-unit board 50 configured with multiple unit boards 51. The same wiring pattern is formed on each of the multiple unit boards 51. Each of the fiducial mark Mt and the alternative mark Mb is set at the same position and has the same shape in the wiring pattern. The second template is the same as the first template (template 70).

In the configuration described above, since the wiring pattern is the same on each of the multiple unit boards 51, one of the characteristic sections 53 which are set as the fiducial mark Mt and one characteristic section 53 which is set as the alternative mark Mb are set at the same position and have the same shape in the unit board 51. In this manner, in the supplementary process, it is possible to share the first template (template 70) as the second template. Accordingly, it is possible to omit generation and management of the second template (template 70).

In addition, in the first and second embodiments, image processing device 30 establishes a positional relationship between the fiducial mark Mt and the alternative mark Mb based on the positional relationship between the multiple unit boards 51 (S22).

In the configuration described above, in a case where the positional relationship between the multiple unit boards 51 is set, a positional relationship between the multiple characteristic sections 53 is identified based on the setting of the positional relationship between the multiple unit boards 51. By using such properties, the setting of the positional relationship between the multiple unit boards 51 enables the positional relationship between the fiducial mark Mt and the alternative mark Mb to be established. In this manner, it is possible to omit a request such as a direct coordinate input from the operator. Accordingly, it is possible to improve processing efficiency in the image processing and to shorten a time taken for the supplementary process.

### Modified Examples of First and Second Embodiments

In the second embodiment, mark acquisition section 36 identifies a unit board having the undetectable fiducial mark Mt, selects one of the multiple candidate marks based on the candidate table 80, and automatically acquires the mark as the alternative mark Mb. In this respect, mark acquisition section 36 may display candidate table 80 on display device 23 and accept selection by the operator like the first embodiment. In addition, mark acquisition section 36 may display candidate table 80 with an image obtained by imaging the region containing the multiple candidate marks in candidate table 80, or may display the image instead of candidate table 80, so as to accept selection by the operator.

Alternatively, mark acquisition section 36 may be configured to automatically select another unit board 51 in the vicinity of the unit board 51 having the undetectable fiducial mark Mt, based on the positional information between the multiple unit boards 51 which is stored in storage device 22, instead of candidate table 80, and to acquire the characteristic section 53 of the other unit board 51 as the alternative mark Mb. With this configuration too, it is possible to achieve the same effects as those of the second embodiment.

In the first and second embodiments, the board 50 is a multi-unit board 50. In this respect, image processing device 30 may execute the image processing of recognizing the reference position of the board, with a normal board having one electronic circuit product as a whole, which is used as a target. In addition, the shape of the alternative mark Mb may be different from the shape of the fiducial mark Mt. In this case, detecting section 32 scans the image data 60 by using the second template 70 different from the first template that is used in the scanning of the fiducial mark Mt as a target.

In addition, in the first and second embodiments, image processing device 30 is configured to be applied to control device 20 of component mounting machine 10. In this respect, the board image processing device and the board image processing method can be applied to other production equipment such as a screen printer or a mounting inspector or host computer 2. With this configuration too, it is possible to achieve the same effects as those of the first and second embodiments.

### Reference Signs List

1: production line, 2: host computer, 10: component mounting machine, 11: board conveyance device, 12: component supply device, 12a: feeder, 13: component transfer device, 13a: head driving device, 13b: moving table, 13c: mounting head, 14: component camera, 15: board camera, 20: control device, 21: mounting control section, 22: storage device, 23: display device, 24: input device, 30: image processing device, 31: image acquisition section (first image acquisition section, second image acquisition section), 32: detecting section (first detecting section, second detecting section), 35: position recognition section (first position recognition section, second position recognition section), 36: mark acquisition section, 50: board, 51: unit board, 51A to 51E: unit board for reference, 52: land (wiring pattern), 53: characteristic section, 60: image data, 60A: first image data, 60B: second image data, 61: designation region, 70: template (first template, second template), 71: reference line, 80: candidate table, Ps: supply position, Mt: fiducial mark, Mb: alternative mark

## Claims

1. A board image processing device (30) for recognizing a reference position of a board (50) on which a wiring pattern is formed, wherein at least one of one or more characteristic sections (53) contained in the wiring pattern is set as a fiducial mark representing the reference position, the image processing device comprising:
a first image acquisition section (31) configured to acquire first image data (60A)obtained by imaging a region of the board (50) in which the fiducial mark is contained;
a first detecting section (32) configured to detect a position of the fiducial mark by scanning the first image data (60A) by using a first template showing a shape of the fiducial mark;
a first position recognition section (35) configured to recognize the reference position of the board (50) based on a result of detection performed by the first detecting section (32);
a mark acquisition section (36) configured to, in a case where the position of the fiducial mark is not detected by the scanning performed by the first detecting section (32), acquire a different characteristic section (53) that is different from the fiducial mark as an alternative mark instead of the fiducial mark;
a second image acquisition section (31) configured to acquire second image data (60B) obtained by imaging a region of the board (50) in which the alternative mark is contained;
a second detecting section (32) configured to detect the position of the alternative mark by scanning the second image data (60B) by using a second template (70) showing a shape of the alternative mark; and
a second position recognition section (35) configured to recognize the reference position of the board (50) based on a result of the detection performed by the second detecting section (32) and a positional relationship between the fiducial mark and the alternative mark,
wherein the mark acquisition section (36) is configured to display a portion or the entirety of the board (50) for an operator (S21) and accept designation of the alternative mark and an input of the positional relationship between the fiducial mark and the alternative mark (S22) by the operator;
and/or
wherein the mark acquisition section (36) has a candidate table (80) obtained by associating multiple candidate marks of the characteristic sections (53), which are usable as the alternative mark, with a positional relationship between the fiducial mark and each of the multiple candidate marks, and
wherein the mark acquisition section (36) is configured to acquire, as the alternative mark, one of the multiple candidate marks selected based on the positional relationship between the fiducial mark and each of the multiple candidate marks.

2. The board image processing device (30) according to claim 1,
wherein, in the candidate table (80), information on each shape of the candidate marks is associated with the multiple candidate marks, and
wherein the mark acquisition section (36) is configured to acquire, as the alternative mark, one of the multiple candidate marks selected based on a degree of similarity between a shape of the fiducial mark and the shape of each of the multiple candidate marks.

3. The board image processing device (30) according to claim 1 or 2,
wherein the board (50) is a multi-unit board (50) configured with multiple unit boards (51),
wherein the same wiring pattern is formed on each of the multiple unit boards (51),
wherein each of the fiducial mark and the alternative mark is set at the same position and has the same shape in the wiring pattern, and
wherein the second template (70) is the same as the first template (70).

4. The board image processing device (30) according to claim 3,
wherein the second position recognition section (35) establishes a positional relationship between the fiducial mark and the alternative mark based on a positional relationship between the multiple unit boards (52).

5. A board image processing method for recognizing a reference position of a board (50) on which a wiring pattern is formed, wherein at least one of one or more characteristic sections (53) contained in the wiring pattern is set as a fiducial mark representing the reference position, the image processing method comprising:
a first image acquiring step (S12) of acquiring first image data (60A) obtained by imaging a region of the board (50) in which the fiducial mark is contained;
a first detecting step (S13) of detecting a position of the fiducial mark by scanning the first image data (60A) by using a first template (70) showing a shape of the fiducial mark;
a first position recognizing step (S15) of recognizing the reference position of the board (50) based on a result of detection performed in the first detecting step (S13);
a mark acquiring step (S20) of, in a case where the position of the fiducial mark is not detected by the scanning performed in the first detecting step (S13), acquiring a different characteristic section that is different from the fiducial mark as an alternative mark instead of the fiducial mark;
a second image acquiring step (S12) of acquiring second image data (60B) obtained by imaging a region of the board in which the alternative mark is contained;
a second detecting step (S13) of detecting the position of the alternative mark by scanning the second image data (60B) by using a second template (70) showing a shape of the alternative mark; and
a second position recognizing step (S15) of recognizing the reference position of the board (50) based on a result of the detection performed by the second detecting step (S13) and a positional relationship between the fiducial mark and the alternative mark;
wherein, in the mark acquiring step (S20), a portion or the entirety of the board (50) is displayed for an operator (S21) and designation of the alternative mark and an input of the positional relationship between the fiducial mark and the alternative mark (S22) by the operator is accepted;
and/or
wherein, in the mark acquiring step (S20), as the alternative mark, one of multiple candidate marks is acquired from a candidate table (80), which is obtained by associating multiple candidate marks of the characteristic sections (53), which are usable as the alternative mark, with a positional relationship between the fiducial mark and each of the multiple candidate marks, and the one of the multiple candidate marks is selected based on the positional relationship between the fiducial mark and each of the multiple candidate marks.

## Patentansprüche

1. Plattenbildverarbeitungsvorrichtung (30) zur Erkennung einer Referenzposition einer Platte (50), auf welcher ein Verdrahtungsmuster ausgebildet ist, wobei mindestens einer von einem oder mehreren charakteristischen Abschnitten (53), die in dem Verdrahtungsmuster enthalten sind, als eine Referenzmarkierung festgelegt ist, die die Referenzposition repräsentiert, wobei die Plattenbildverarbeitungsvorrichtung umfasst:
einen ersten Bildbezugsabschnitt (31), der konfiguriert ist, erste Bilddaten (60A) zu beziehen, die durch Abbilden eines Bereichs der Platte (50) erhalten werden, in welchem die Referenzmarkierung enthalten ist;
einen ersten Erfassungsabschnitt (32), der konfiguriert ist, eine Position der Referenzmarkierung durch Scannen der ersten Bilddaten (60A) unter Verwendung einer ersten Vorlage zu erfassen, die eine Form der Referenzmarkierung zeigt;
einen ersten Positionserkennungsabschnitt (35), der konfiguriert ist, die Referenzposition der Platte (50) basierend auf einem Ergebnis einer Erfassung zu erkennen, die von dem ersten Erfassungsabschnitt (32) ausgeführt wird;
einen Markierungsbezugsabschnitt (36), der konfiguriert ist, in einem Fall, in welchem die Position der Referenzmarkierung durch das von dem ersten Erfassungsabschnitt (32) ausgeführte Scannen nicht erfasst wird, einen anderen charakteristischen Abschnitt (53), der sich von der Referenzmarkierung unterscheidet, als eine alternative Markierung anstelle der Referenzmarkierung zu beziehen;
einen zweiten Bildbezugsabschnitt (31), der konfiguriert ist, zweite Bilddaten (60B) zu beziehen, die durch Abbilden eines Bereichs der Platte (50) erhalten werden, in welchem die alternative Markierung enthalten ist;
einen zweiten Erfassungsabschnitt (32), der konfiguriert ist, die Position der alternativen Markierung durch Scannen der zweiten Bilddaten (60B) unter Verwendung einer zweiten Vorlage (70) zu erfassen, die eine Form der alternativen Markierung zeigt; und
einen zweiten Positionserkennungsabschnitt (35), der konfiguriert ist, die Referenzposition der Platte (50) basierend auf einem Ergebnis der Erfassung zu erkennen, die von dem zweiten Erfassungsabschnitt (32) ausgeführt wird und einer Positionsbeziehung zwischen der Referenzmarkierung und der alternativen Markierung,
wobei der Markierungsbezugsabschnitt (36) konfiguriert ist, einen Abschnitt oder die Gesamtheit der Platte (50) für einen Benutzer (S21) anzuzeigen und eine Bestimmung der alternativen Markierung und eine Eingabe der Positionsbeziehung zwischen der Referenzmarkierung und der alternativen Markierung (S22) durch den Benutzer anzunehmen;
und/oder
wobei der Markierungsbezugsabschnitt (36) eine Kandidatentabelle (80) aufweist, die durch Verknüpfung mehrerer Kandidatenmarkierungen der charakteristischen Abschnitte (53), die als alternative Markierung verwendbar sind, mit einer Positionsbeziehung zwischen der Referenzmarkierung und jeder der mehreren Kandidatenmarkierungen erhalten wird, und
wobei der Markierungsbezugsabschnitt (36) konfiguriert ist, als alternative Markierung eine der mehreren Kandidatenmarkierungen zu beziehen, die basierend auf der Positionsbeziehung zwischen der Referenzmarkierung und jeder der mehreren Kandidatenmarkierungen ausgewählt wird.

2. Die Plattenbildverarbeitungsvorrichtung (30) nach Anspruch 1,
wobei in der Kandidatentabelle (80) Informationen über jede Form der Kandidatenmarkierungen mit den mehreren Kandidatenmarkierungen verknüpft sind, und
wobei der Markierungsbezugsabschnitt (36) konfiguriert ist, als alternative Markierung eine der mehreren Kandidatenmarkierungen zu beziehen, die basierend auf einem Ausmaß der Ähnlichkeit zwischen einer Form der Referenzmarkierung und der Form von jeder der mehreren Kandidatenmarkierungen ausgewählt wird.

3. Die Plattenbildverarbeitungsvorrichtung (30) nach Anspruch 1 oder 2,
wobei die Platte (50) eine Platte (50) mit mehreren Einheiten ist, die mit mehreren Einheitsplatten (51) konfiguriert ist,
wobei dasselbe Verdrahtungsmuster auf jeder der mehreren Einheitsplatten (51) ausgebildet ist,
wobei sowohl die Referenzmarkierung als auch die alternative Markierung an derselben Position festgelegt ist und dieselbe Form in dem Verdrahtungsmuster aufweist, und
wobei die zweite Vorlage (70) dieselbe wie die erste Vorlage (70) ist.

4. Die Plattenbildverarbeitungsvorrichtung (30) nach Anspruch 3,
wobei der zweite Positionserfassungsabschnitt (35) eine Positionsbeziehung zwischen der Referenzmarkierung und der alternativen Markierung basierend auf einer Positionsbeziehung zwischen den mehreren Einheitsplatten (52) herstellt.

5. Plattenbildverarbeitungsverfahren zur Erkennung einer Referenzposition einer Platte (50), auf welcher ein Verdrahtungsmuster ausgebildet ist, wobei mindestens einer von einem oder mehreren charakteristischen Abschnitten (53), die in dem Verdrahtungsmuster enthalten sind, als eine Referenzmarkierung festgelegt ist, die die Referenzposition repräsentiert, wobei das Bildverarbeitungsverfahren umfasst:
einen ersten Bildbezugsschritt (S12) zur Beziehung erster Bilddaten (60A), die durch Abbilden eines Bereichs der Platte (50) erhalten werden, in welchem die Referenzmarkierung enthalten ist;
einen ersten Erfassungsschritt (S13) zur Erfassung einer Position der Referenzmarkierung durch Scannen der ersten Bilddaten (60A) unter Verwendung einer ersten Vorlage (70), die eine Form der Referenzmarkierung zeigt;
einen ersten Positionserkennungsschritt (S15) zur Erkennung der Referenzposition der Platte (50) basierend auf einem Ergebnis einer in dem ersten Erfassungsschritt (S13) ausgeführten Erfassung;
einen Markierungsbezugsschritt (S20) zur Beziehung eines anderen charakteristischen Abschnitts, der von der Referenzmarkierung abweicht, als alternative Markierung anstelle der Referenzmarkierung, wenn die Position der Referenzmarkierung durch das in dem ersten Erfassungsschritt (S13) ausgeführte Scannen nicht erfasst wird;
einen zweiten Bildbezugsschritt (S12) zur Beziehung zweiter Bilddaten (60B), die durch Abbilden eines Bereichs der Platte erhalten werden, in welchem die alternative Markierung enthalten ist;
einen zweiten Erfassungsschritt (S13) zur Erfassung der Position der alternativen Markierung durch Scannen der zweiten Bilddaten (60B) unter Verwendung einer zweiten Vorlage (70), die eine Form der alternativen Markierung zeigt; und
einen zweiten Positionserkennungsschritt (S15) zur Erkennung der Referenzposition der Platte (50) basierend auf einem Ergebnis der von dem zweiten Erfassungswert (S13) ausgeführten Erfassung und einer Positionsbeziehung zwischen der Referenzmarkierung und der alternativen Markierung;
wobei in dem Markierungsbezugsschritt (S20) ein Abschnitt oder die Gesamtheit der Platte (50) für einen Benutzer (S21) angezeigt wird und eine Bestimmung der alternativen Markierung und eine Eingabe der Positionsbeziehung zwischen der Referenzmarkierung und der alternativen Markierung (S22) durch den Benutzer angenommen wird;
und/oder
wobei in dem Markierungsbezugsschritt (S20) als alternative Markierung eine von mehreren Kandidatenmarkierungen aus einer Kandidatentabelle (80) bezogen wird, die durch Verknüpfung mehrerer Kandidatenmarkierungen der charakteristischen Abschnitte (53), die als alternative Markierung verwendbar sind, mit einer Positionsbeziehung zwischen der Referenzmarkierung und jeder der mehreren Kandidatenmarkierungen erhalten wird, und die eine der mehreren Kandidatenmarkierungen basierend auf der Positionsbeziehung zwischen der Referenzmarkierung und jeder der mehreren Kandidatenmarkierungen ausgewählt wird.

## Revendications

1. Dispositif de traitement d'image de carte (30) pour reconnaître une position de référence d'une carte (50) sur laquelle un schéma de câblage est constitué, dans lequel au moins une d'une ou plusieurs sections de caractéristiques (53) contenues dans le schéma de câblage est définie en tant que marque de repère représentant la position de référence, le dispositif de traitement d'image comprenant :
une première section d'acquisition d'image (31) configurée pour acquérir des premières données d'image (60A) obtenues par une prise d'image d'une zone de la carte (50) dans laquelle la marque de repère est contenue ;
une première section de détection (32) configurée pour détecter une position de la marque de repère en analysant les premières données d'image (60A) en utilisant un premier gabarit affichant une forme de la marque de repère ;
une première section de reconnaissance de position (35) configurée pour reconnaître la position de référence de la carte (50) selon un résultat d'une détection exécutée par la première section de détection (32) ;
une section d'acquisition de marque (36) configurée pour, dans un cas où la position de la marque de repère n'est pas détectée par l'analyse exécutée par la première section (32), acquérir une section de caractéristiques différente (53) qui est différente de la marque de repère en tant que marque de substitution au lieu de la marque de repère ;
une deuxième section d'acquisition d'image (31) configurée pour acquérir des deuxièmes données d'image (60B) obtenues par une prise d'image d'une zone de la carte (50) dans laquelle la marque de repère de substitution est contenue ;
une deuxième section de détection (32) configurée pour détecter la position de la marque de substitution en analysant les deuxièmes données d'image (60B) en utilisant un deuxième gabarit (70) affichant une forme de la marque de substitution ; et
une deuxième section de reconnaissance de position (35) configurée pour reconnaître la position de référence de la carte (50) selon un résultat de la détection exécutée par la deuxième section de détection (32) et une relation positionnelle entre la marque de repère et la marque de substitution,
dans lequel la section d'acquisition de marque (36) est configurée pour afficher une partie ou la totalité de la carte (50) pour un opérateur (S21) et accepter une désignation de la marque de substitution et une entrée de la relation positionnelle entre la marque de repère et la marque de substitution (S22) par l'opérateur ;
et/ou
dans lequel la section d'acquisition de marque (36) présente une table de candidats (80) obtenue en associant plusieurs marques candidates des sections de caractéristiques (53), qui sont utilisables en tant que marque de substitution, avec une relation positionnelle entre la marque de repère et chacune des plusieurs marques candidates, et
dans lequel la section d'acquisition de marque (36) est configurée pour acquérir, en tant que marque de substitution, une des plusieurs marques candidates sélectionnées selon la relation positionnelle entre la marque de repère et chacune des plusieurs marques candidates.

2. Le dispositif de traitement d'image de carte (30) selon la revendication 1,
dans lequel, dans la table de candidats (80), des informations sur chaque forme des marques candidates sont associées aux plusieurs marques candidates, et
dans lequel la section d'acquisition de marque (36) est configurée pour acquérir, en tant que marque de substitution, une des plusieurs marques candidates sélectionnées selon un degré de similarité entre une forme de la marque de repère et la forme de chacune des plusieurs marques candidates.

3. Le dispositif de traitement d'image de carte (30) selon la revendication 1 ou 2,
dans lequel la carte (50) est une carte à plusieurs unités (50) configurée avec plusieurs cartes d'unité (51),
dans lequel le même schéma de câblage est constitué sur chacune des plusieurs cartes d'unité (51),
dans lequel chacune de la marque de repère et de la marque de substitution est définie sur la même position et présente la même forme dans le schéma de câblage, et
dans lequel le deuxième gabarit (70) est le même que le premier gabarit (70).

4. Le dispositif de traitement d'image de carte (30) selon la revendication 3,
dans lequel la deuxième section de reconnaissance de position (35) établit une relation positionnelle entre la marque de repère et la marque de substitution selon une relation positionnelle entre les plusieurs cartes d'unité (52).

5. Procédé de traitement d'image de carte pour reconnaître une position de référence d'une carte (50) sur laquelle un schéma de câblage est constitué, dans lequel au moins une d'une ou plusieurs sections de caractéristiques (53) contenues dans le schéma de câblage est définie en tant que marque de repère représentant la position de référence, le dispositif de traitement d'image comprenant :
une première étape d'acquisition d'image (S12) d'acquisition de premières données d'image (60A) obtenues par une prise d'image d'une zone de la carte (50) dans laquelle la marque de repère est contenue ;
une première étape de détection (S13) de détection d'une position de la marque de repère en analysant les premières données d'image (60A) en utilisant un premier gabarit (70) affichant une forme de la marque de repère ;
une première étape de reconnaissance de position (S15) de reconnaissance de la position de référence de la carte (50) selon un résultat d'une détection exécutée à la première étape de détection (S13) ;
une étape d'acquisition de marque (36) d'acquisition, dans un cas où la position de la marque de repère n'est pas détectée par l'analyse exécutée à la première étape de détection (S13), d'une section de caractéristiques différente qui est différente de la marque de repère en tant que marque de substitution au lieu de la marque de repère ;
une deuxième étape d'acquisition d'image (S12) d'acquisition de deuxièmes données d'image (60B) obtenues par une prise d'image d'une zone de la carte dans laquelle la marque de repère de substitution est contenue ;
une deuxième étape de détection (S13) de détection de la position de la marque de substitution en analysant les deuxièmes données d'image (60B) en utilisant un deuxième gabarit (70) affichant une forme de la marque de substitution ; et
une deuxième étape de reconnaissance de position (S15) de reconnaissance de la position de référence de la carte (50) selon un résultat de la détection exécutée à la deuxième étape de détection (S13) et une relation positionnelle entre la marque de repère et la marque de substitution ;
dans lequel, à l'étape d'acquisition de marque (S20), une partie ou la totalité de la carte (50) est affichée pour un opérateur (S21) et une désignation de la marque de substitution et une entrée de la relation positionnelle entre la marque de repère et la marque de substitution (S22) par l'opérateur est acceptée ;
et/ou
dans lequel, à l'étape d'acquisition de marque (S20), en tant que marque de substitution, une des plusieurs marques candidates est acquise à partir d'une table de candidats (80), qui est obtenue en associant plusieurs marques candidates des sections de caractéristiques (53), qui sont utilisables en tant que marque de repère, avec une relation positionnelle entre la marque de repère et chacune des plusieurs marques candidates, et l'une des plusieurs marques candidates est sélectionnée selon la relation positionnelle entre la marque de repère et chacune des plusieurs marques candidates.
